# EUROPEAN PATENT SPECIFICATION

(11) **EP 1 984 467 B1**
(45) Date of publication and mention of the grant of the patent: **21.03.2012**
(21) Application number: 07735076.7
(22) Date of filing: 02.01.2007
(51) Int. Cl.: C09G 1/04, C09G 1/02, H01L 21/321

(54) **BARRIER SLURRY COMPOSITIONS AND BARRIER CMP METHODS**
BARRIERESCHLAMMZUSAMMENSETZUNGEN UND CMP-BARRIEREVERFAHREN
COMPOSITIONS DE COULIS POUR BARRIÈRE ET PROCÉDÉS DE CMP DE BARRIÈRE

(30) Priority: 03.02.2006 WO PCT/EP2006/002851
(43) Date of publication of application: 29.10.2008
(73) Proprietor: Freescale Semiconductor, Inc., Austin, TX 78735 (US)
(72) Inventor: MONNOYER, Philippe, 01390 Vantaa (FI)
(74) Representative: Ferro, Frodo Nunes
(86) International application number: PCT/IB2007/050817
(87) International publication number: WO 2007/102138

(56) References cited:
- EP-A- 1 586 614
- WO-A-2006/074248
- WO-A-2007/087831
- US-A- 6 001 730
- US-A1- 2003 211 745
- US-A1- 2004 224 521
- US-A1- 2005 005 525

## Description

### Background of the invention

During the manufacture of integrated circuit devices it is increasingly becoming necessary to perform CMP on wafers bearing metallic contacts and interconnects and having low or ultra-low dielectric constant (LK or ULK) interlayer dielectrics. Each CMP process normally includes several different phases, starting with polishing of excess metal and ending with a barrier CMP phase during which the polishing process seeks to remove unwanted portions of a barrier layer that underlies the metal layer. Typically, a dedicated slurry is used for the barrier-CMP phase of polishing and this slurry is referred to as a barrier slurry.

The layers underlying the barrier layer can vary: at present there is generally a cap layer protecting an underlying low-k or ULK dielectric material but, especially as higher levels of integration are attained (e.g. the 45 nm node), there will be no cap layer between the barrier layer and the underlying low-k or ULK dielectric material. During barrier-CMP different approaches are possible: the barrier polishing can stop on the cap layer, leaving the underlying dielectric material protected, or the polishing can stop when the cap layer has been removed. I n either case it is undesirable to remove the underlying dielectric material.

Conventional barrier slurry compositions, such as CuS1351 manufactured by Rohm & Haas, are designed so as to have a pattern of selectivities which will tend to remove metal and barrier layer material at relatively fast rates and which will also remove cap layer material at a significant rate. Although process control is exercised with a view to stopping the barrier CMP process before the low-k or ULK dielectric material has become exposed, often some of the underlying low-k or ULK dielectric material does become exposed. In such a case, because the conventional barrier slurries have a significant removal rate with respect to low-k materials (such as SiOC and porous SiOC), significant amounts of the low-k dielectric material tend to be removed, which is undesirable.

Moreover, in future processes involving use of ULK dielectric materials without a cap layer intervening between the dielectric and the barrier layer, the dielectric material will become exposed as soon as the barrier layer begins to clear. If conventional barrier slurries were to be used in this case, then significant amounts of the dielectric material would be Polished away.

Accordingly, there is a need for a barrier slurry composition which can remove metal, barrier layer material and, if necessary, cap layer material at a reasonably-fast rate but which will remove none, or less, of the underlying low-k or ULK dielectric material.

### Summary of the invention

The present invention provides a barrier slurry composition as described in the accompanying claims.

The present invention provides a barrier GVIP method as described in the accompanying claims.

### Brief description of the drawings

Figure 1 is a graph illustrating the results of experiments relating to the removal rate of various materials using a core barrier slurry composition according to a first embodiment of the present invention, and a comparative example;
Figure 2 is a graph illustrating the results of experiments relating to the removal rate of various materials using different barrier slurry compositions according to the second embodiment of the present invention;
Figure 3 is a graph illustrating the polishing rate selectivity (rate of removal of SiO₂ preferentially compared to Black Diamond IIX ™ from Applied Materials) for different barrier slurry compositions according to the second embodiment of the present invention;
Figure 4 is a diagram illustrating one hypothesis regarding possible arrangements of molecules in certain barrier slurry compositions according to the second embodiment of the invention relative to surface pores in a layer of Slack Diamond IIX dielectric material;
Figure 5 is a graph indicating the amount of sulphur remaining on the surface of a wafer after barrier-CMP using different barrier slurry compositions according to the second embodiment of the invention followed by wafer cleaning in a wafer scrubber;
Figure 6 is a graph showing porosimetry data for Black Diamond IIX after polishing using barrier slurry compositions according to the second embodiment of the invention and certain comparative examples;
Figure 7 is a graph illustrating the removal rates of various materials using different barrier slurry compositions according to the first and second embodiments of the present invention, and a comparative example, when polishing duration is varied;
Figure 8 is a graph illustrating the results of experiments relating to the removal rate of various materials using different barrier slurry compositions according to the second embodiment of the present invention in which the concentration of a first additive varies;
Figure 9 is a graph illustrating the results of experiments relating to the defectivity observed on a wafer after barrier-CMP using different barrier slurry compositions according to the third embodiment of the present invention in which the concentration of a second additive (salt) varies;
Figure 10 is a graph illustrating the defect counts (defectivity) on various materials using different barrier slurry compositions according to the second embodiment of the present invention in which a first additive (surfactant) varies;
Figure 11 is a graph illustrating the removal rates of various materials using barrier slurry compositions according to the third embodiment of the present invention in which the concentration of a particular second additive (ammonium nitrate) varies (in the presence of a first additive (AOT at 0.01 wt. %)); and
Figure 12 is a graph illustrating the removal rates of various materials using barrier slurry compositions according to the third embodiment of the present invention in which the concentration of another second additive (borax) varies (in the presence of a first additive (ACT at 0.01 wt. %)).

### Detailed description of the preferred embodiments

### Barrier Slurry Compositions

In the present invention, a new barrier slurry composition has been developed that allows copper, conventional cap layer materials and conventional barrier layer materials to be removed at a reasonably fast rate during barrier-CMP, while polishing significantly less on various low-k or ULK dielectrics (notably, SOC-based dielectric materials such as Black Diamond I^{™} and Black Diamond IIX^{™} from Applied Materials).

A first embodiment of the invention provides a first "core" composition for a barrier slurry. This core composition produces an advantageous pattern of removal rates of metal, barrier layer material, cap layer material and low-k or ULK dielectric material. Second and third embodiments of the invention provide barrier slurry compositions including the core composition mixed with a first additive, and/or a second additive, respectively.

### First Embodiment

The "core" barrier slurry composition according to the first embodiment of the invention will now be described.

The core barrier slurry composition consists of the different following compounds dissolved in deionized water: an oxidizing agent, an abrasive, a complexing agent and, optionally, a corrosion inhibitor, at a pH which is not basic, i.e. which is 7.0 or below.

Appropriate and advantageous amounts of each component in the framework of the present invention are indicated in the appended claims.

The oxidizing agent can be selected from a variety of known oxidising agents, including: hydrogen peroxide, organic peroxides, persulfates, (per)iodates such as potassium iodate and periodate, bromates and perbromates, peroxodisulfates and perchlorates. The presently-preferred oxidizing agent is hydrogen peroxide. It has been found advantageous to use a concentration of oxidising agent, such as in particular of hydrogen peroxide, of at most 0.05 % by weight with respect to the overall, final aqueous barrier slurry composition, and in particular between 0.010 and 0.025 % by weight, e.g. around 0.017 % by weight. The use of hydrogen peroxide concentrations in this range has been found to enable similar removal rates of SiO₂ and copper to be achieved, ensuring good planarization.

The abrasive can be selected from a variety of known particulate abrasive materials, including: inorganic oxides, metal carbides or nitrides, and polymer particles or coated polymer particles. The abrasive particles can have a core-shell structure of the various cited materials. Advantageously used inorganic oxide abrasives include silica (in various forms), alumina, cerium oxide, zirconia and manganese oxide. The presently-preferred abrasive is colloidal silica. A generally appropriate amount of abrasive is between 1 and 10 % by weight with respect to the overall, final aqueous barrier slurry composition.

It has been found to be advantageous if the colloidal silica abrasive particles have an average diameter in the range of 5 to 200 nm, more preferably around 70 nm. It has also been found to be advantageous for the colloidal silica abrasive particles to be peanut-shaped. The colloidal silica abrasive PL2 manufactured by FUSO of Japan has particles that are peanut-shaped (2 unit particles permanently aggregated) and have an average diameter of approximately 70 nm with a unit particle diameter of 25 nm; this abrasive has been used successfully in barrier slurry compositions embodying the present invention.

The complexing agent can be selected from a variety of known complexing agents. Typical complexing agents contain amine or other nitrogen-based functional groups, or oxygen-based functional groups such as hydroxyl groups or carboxylate groups, and usually contain more than one metal coordination site in the molecule in order to have a chelating effect. Examples of appropriate carboxylate-based complexing agents useful in the present invention include (the acids or partially or completely deprotonated carboxylates deriving from) citric acid, tartaric acid, succinic acid, oxalic acid, acetic acid, adipic acid, butyric acid, capric acid, caproic acid, caprylic acid, glutaric arid, glycolic acid, formic acid, fumaric acid, lactic acid, lauric acid, malic acid, maleic acid, malonic acid, myristic acid, plamitic acid, phthalic acid, propionic acid, pyruvic arid, stearic acid, valeric acid, and combinations thereof. Salts of such carboxylic acids include ammonium, potassium and sodium salts. The presently-preferred complexing agent is citric acid and/or citrate. Monobasic, dibasic or tribasic ammonium, potassium or sodium citrate may be used. Ethylenediaminetetraacetic acid (EDTA) can also be used as a complexing agent, as can its salts, for example sodium, potassium and calcium salts such as Na₂ETDA, Na₄ETDA, K₄ETDA, Ca₂ETDA A generally appropriate amount of complexing agent is between 0.01 and 3 % by weight with respect to the overall, final aqueous barrier slurry composition, and less than 0.4 % by weight, for example 0.05 to 0.4 % by weight of complexing agent such as citrate is particularly appropriate.

The corrosion inhibitor can be selected from a variety of known corrosion inhibitors, induing N-heterocycles, and in particular heterocydic systems with at least two nitrogen atoms in the same ring, such as triazoles, such as 1,2,4-triazole, benzotriazoles and imidazoles. Another group of corrosion inhibitors that can be contemplated for used here are uric acid and analogous compounds, such as adenine, caffeine and purine. The presently-preferred corrosion inhibitor is benzotriazole.

One advantageous example of the core aqueous barrier slurry composition according to the invention has the composition indicated in Table 1 below, the pH being adjusted to 4.5 to 5.0, such as to 4.8 to 4.9.

**Table 1**

| Substance | Amount (Weight/Weight Percent) |
|---|---|
| hydrogen peroxide | 0.017 |
| colloidal silica abrasive | 5.0 |
| benzotriazole | 0.002 |
| citric acid | 0.15 |

Moreover, certain additional components can be included in the "core" barrier slurry composition without negating the advantageous effects of the invention. Notably, a small amount of an additional corrosion inhibitor, such as 1,2,4-triazole (up to approximately 0.2 weight percent), can be included in the core composition in order to produce smooth copper surfaces at the end of CMP. Moreover, other conventional additives - for example: accelerators, lubricating agents, biocidal agents, etc. - can in principle be included in the core composition, if desired. However, the compositions according to the present invention will preferably consist essentially of (other than water), the basic components a) oxidizer, b) abrasive, c) complexing agent, d) corrosion inhibitor (optional), as well as a pH adjusting agent if required such as ammonia, and, advantageously, one or other of a surfactant-type additive e) as further defined in the second embodiment below, and/or f) a salt as defined in the third embodiment below. The compositions according to the present invention preferably do not comprise long-chain amines, or reducing agents.

It is advantageous for the pH of the above-mentioned core composition to be adjusted so as to be in the range from 4.0 to 5.7. It is particularly advantageous for the pH of the above-mentioned core composition to be adjusted so as to be in the range from 4.7 to 5.0. This can be achieved conveniently using, for example,-ammonia.

In order to demonstrate the advantageous properties of the above-described core barrier slurry composition, experiments were conducted involving the performance of barrier-CMP processes on copper, SO₂ (a conventional cap layer material), TaN (a conventional barrier layer material), a non-porous SiOC low-k dielectric material (Black Diamond I manufactured by Applied Materials) and a porous SOC ULK dielectric material (Black Diamond IIX manufactured by Applied Materials).

In these experiments, barrier-CMP processes were performed using a barrier slurry having the "core" composition according to the above-described example (as in Table 1) and using a OiS 1351 barrier slurry as a comparative example.

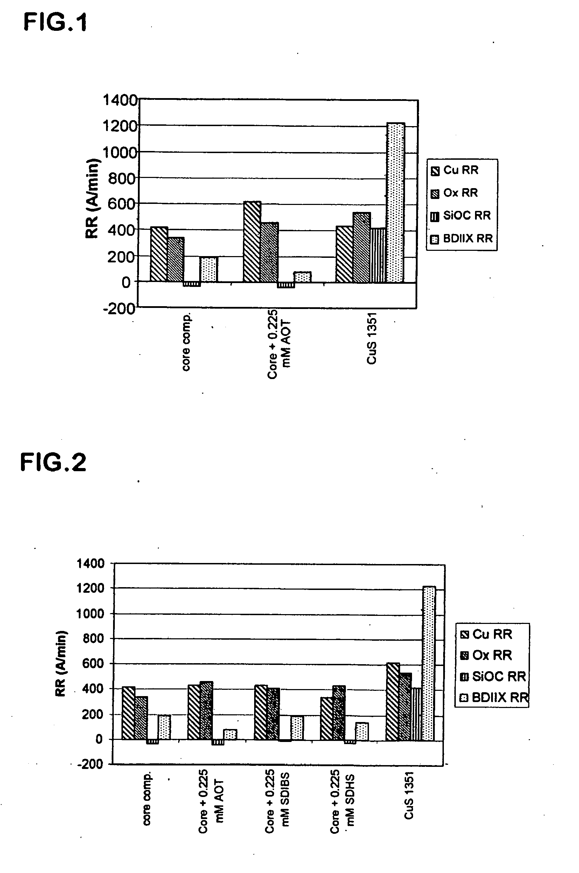

The experiments involved performing CMP on full sheet 200mm wafers at ambient temperature (for example, 25°C). A first set of experiments was performed using a Mirra polishing tool from Applied Materials under the following conditions: a polishing pressure of 13,789.514 Pascals (2 psi), a platen speed of 120 rpm, head speed of 114rpm, conditioning sweep 12/minute, slurry flow rate of 200mUminute and using a "Vsion" polishing pad from Rohm and Haas. The results of this first set of experiments are illustrated in Fig.1.

It can be seen from Fg.1 that the conventional barrier slurry removes copper at a rate of around 60 nm per minute (600 angstroms per minute). The removal rate of SiO₂ cap layer material is around 50 nm per minute (500 Å per minute). It can also be seen that the removal rate for non-porous SiOC, a low-k dielectric material, is high. The conventional barrier slurry, has an extremely high removal rate for the ULK material Black Diamond IIX

Fig.1 shows that the barrier slurry having the "core" composition according to the above-described example still produces a reasonably-high removal rate of copper (just over 40 nm/minute - 400 Å/minute) and a removal rate of SiO₂ cap layer material that is still significant. However, in contrast to the comparative example, there is zero or negligible removal of SiOC. (The value indicated in Fig.1 is slightly negative but this is an artefact coming from the ellipsometer that was used to measure the thicknesses after polish. The actual removal rate is close to zero.)

Fig.1 indicates that the core composition according to the above-described first example produces a low, but measurable, removal rate of Black Diamond IIX. However, it was realized that it would be possible to produce a still-lower removal rate of Black Diamond IIX because the purity of the deionized water used in the first set of experiments was not optimum (the resistivity was less than 4MOhm.cm). Moreover, an electron-beam curing technique (which has now been superseded) had been applied when forming the layer of Bladc Diamond IIX on the wafers employed in the experiments.

More particularly, by using ultrapure deionized water (resistivity 18.2 MOhm.cm), Black Diamond IIX layers that had been UV-cured, and fully-controlled conditions, it has been possible to obtain a negligible (approximately zero) removal rate for Black Diamond IIX using the core composition according to the above-described example. This was achieved using an F-REX300S polishing tool from Ebara and the following polishing conditions: a polishing pressure of 13,789.514 Pascals (2 psi), a platen speed of 110rpm, head speed of 107rpm, conditioning sweep 10/minute, slurry flow rate of 200mUminute and using a "Vsion" polishing pad from Rohm and Haas.

Incidentally, the other results illustrated in Fig.1 are not significantly degraded by the use of less-than-ultrapure deionized water in the first set of experiments. Moreover, although not illustrated in Fog.1, the removal rate of TaN barrier layer material is satisfactorily high using the barrier slurry core composition according to the above-described example.

The results in Fg.1 indicate that, in systems where a low-k dielectric material such as SiOC underlies the barrier layer, the barrier slurry composition according to the first embodiment of the present invention enables barrier-CMP to be performed in a realistic time frame and substantially without removing the SiOC low-k dietectric material (or only removing an amount that is highly reduced compared to the prior art). It can be considered that the barrier-CMP process will stop on the SiOC dielectric without external process control (i.e. it will self-stop), because the selectivity of the process is substantially total with regard to preferential removal of SiO₂ cap layer material relative to the underlying SiOC

I n a similar way, the results in Fig.1 indicate that, in systems where a ULK dielectric material such as Black Diamond IIX underlies the barrier layer, the barrier slurry composition according to the first embodiment of the present invention enables barrier-CMP to be performed in a realistic time frame and with a significantly reduced removal rate of the ULK dielectric material compared to the prior art.

Moreover, the fact that the barrier slurry composition according to the first embodiment of the invention does not polish Black Diamond I (non-porous SiOC) renders it possible to envisage a system in which Black Diamond I is used as a cap layer over the more delicate porous SiOC Black Diamond IIX material, in which case a barrier-CMP process using-the composition according to the first embodiment would self-stop on the Black Diamond I.

Two further aqueous slurry compositions that can be used in the general framework of the present invention are as follows:
1) pH 5.46
   0.42 % H₂O₂ by weight as oxidizer
   2.93 % silica abrasive by weight
   0.29 % by weight of citric acid as complexing agent
   1.14 % by weight of 1,2,4-triazole as corrosion inhibitor
   (the pH being adjusted by ammonia and completed to 100% by weight with deionized water)
2) pH 4.5
   0.15 % H₂O₂ by weight as oxidizer
   3.5 % silica abrasive by weight (PL2 colloidal silica abrasive from FUSO)
   0.15 % by weight of dibasic ammonium citrate as complexing agent
   0.5 % by weight of 1,2,4-triazole as corrosion inhibitor.
   (the pH being adjusted by ammonia and completed to 100% by weight with deionized water)

### Second Embodiment

The second embodiment of the present invention will now be described with reference to Figs.2 to 9.

It has now been found that it can be advantageous to introduce a first additive into the core composition described above. In particular, it has now been found to be advantageous to make use of a first additive which is a surfactant (ionic or non-ionic) including a polar group, PG, and two major chains, X₁ and X₂. The two major chains X₁ and X₂ are either connected directly to the polar group PG or they are connected to a common carbon atom C (or carbon-containing group) which is itself connected to the polar group PG. The first additive has either the following first general formula: 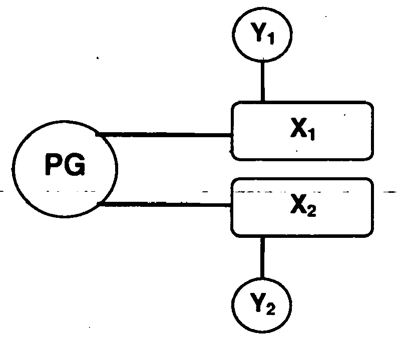 or the following second general formula: 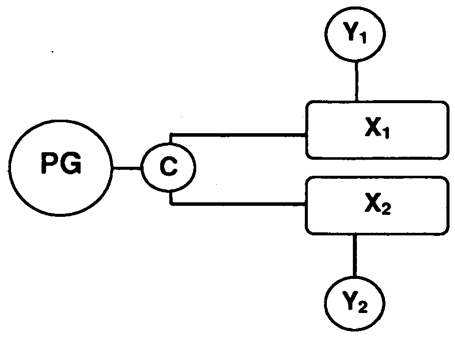 where:
PG is a polar group, for example a sulfate, a sulfosuccinate, a phosphate, an alkyl ammonium halide (the halide can be substituted by any other counter anion such as a sulfate, nitrate, phosphate, sulfite, nitrite, phosphate, etc.), a carboxylate, a sulfonate, a thiol, an alcohol, an ether, a thioether, an ethylene oxide, a propylene oxide, an amine. Currently preferred are charged groups and particularly advantageous are sulphate or sulfonate-based species;
X₁ and X₂ are each non-polar chains or a chain at least a portion of which is non-polar. As well as alkyl or alkenyl chains, these chains may consist of or comprise polysilane or polysiloxane or fluorocarbon (fluoroalkyl) chains. Currently preferred are alkyl chains comprising 2 to 20 carbon atoms, and substituents may be present on these alkyl chains; Y₁ and Y₂ are each a non-polar chain branching off from X₁ and X₂, respectively, and advantageously the branches may contain 1 to 20 carbon atoms,
wherein X₁ may have one or more branches additional to Y₁ and X₂ may have one or more branches additional to Y₂.

In the case where the polar group PG of the first additive consists of an anionic group - such as a sulfate, phosphate, carboxylate, sulfosucanate, etc. - these groups can have sodium, potassium, ammonium, alkyl ammonium or any cation as counter-ions.

Advantageously the additive used contains a dicarboxylate (or polycarboxylate), corresponding to part C in- the second formula,- this part of the molecule containing at least two carboxylate ester functions linked to the chains X₁ and X₂, as well as the polar group PG. The dicarboxylate (or polycarboxylate) part C serves to hold the e.g. alkyl chains X₁ and X₂ separated by a given distance. Although not wishing to be bound by any particular theory, this is thought to enable the fitting into the pores of the material to be pore-sealed and/or protected against polish. It may also be mentioned that dicarboxylate-like species in which one or more of the oxygen atoms of the carboxylate groups has been substituted by sulphur atoms can also be used in this context.

Thus the first additive advantageously has the following structure: 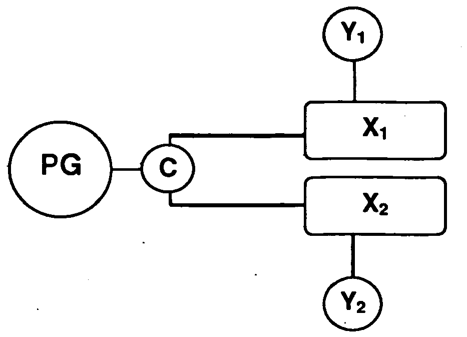 where:
PG is a polar group or charged group,
C is a dicarboxylate unit of formula -O-C(O)-R-C(O)-, where the carboxylate groups form ester linkages with X₁ and X₂, and the R group is covalently bound to polar or charged group PG;
X₁ and X₂ are each non-polar chains or a chain at least a portion of which is non-polar;
Y₁ and Y₂ are each a non-polar chain branching off from X₁ and X₂;
wherein X₁ may have one or more branches additional to Y₁ and X₂ may have one or more branches additional to Y₂.

Advantageously PG here is a sulfate, a phosphate, an alkyl ammonium, a carboxylate, a sulfonate, a thiol, an alcohol, an ether, a thioether, an ethylene oxide, or a propylene oxide. Particularly advantageous are sulphate or sulfonate-based species. The dicarboxylate unit C may advantageously have from 3 to 6 carbon atoms (including the ester carbons), and most advantageously has 4 carbon atoms (succinate derivatives). X₁ and X₂ may be alkyl or alkenyl chains, or chains that consist of or comprise polysilane or polysiloxane or fluorocarbon (fluoroalkyl) chains. Currently preferred for X₁ and X₂ are alkyl chains comprising 2 to 20 carbon atoms, and substituents may be present on these alkyl chains. Most advantageously, X₁ and X₂ are alkyl chains having at least 4 carbon atoms, appropriately between 4 and 10 carbon atoms, and most advantageously having 5, 6, 7 or 8 carbon atoms. Y₁ and Y₂ are advantageously branches containing 1 to 20 carbon atoms, and advantageously are alkyl or alkenyl chains. Most advantageously, branches Y₁ and Y₂ may have 1, 2 or 3 carbon atoms, such as 2 carbon atoms in particular (ethyl branches).

For reasons which will become apparent from the description below, it has been found to be advantageous for the first additive to be sodium bis(2-ethylhexyl) sulfosuccinate (AOT), or compounds based on AOT but having non-polar chains X₁, X₂ of different length from those of AOT and/or having non-polar branches Y₁, Y₂ of different lengths from those in AOT and/or having different positions at which the branches Y₁ and Y₂ branch off from the chains X₁ and X₂. (It is to be noted that in the literature, the surfactant commonly referred to as "Aerosol OT" or "ACT" is referred to as "sodium dioctyl sulfosuccinate", although the octyl groups are actually branched bis(2-ethylhexyl) groups.)

It has been found that the addition of a first additive of the above-described type to the core composition according to the first embodiment can lead to a decrease in the removal rate of Black Diamond IIX ULK dielectric material. This effect further improves the selectivity of the barrier CMP process with regard to the preferential removal of cap layer (or barrier layer) material relative to the underlying ULK dielectric.

In order to demonstrate the advantageous properties of the barrier slurry compositions according to the second embodiment, a second set of experiments, comparable to those giving rise to the data in Fig.1, were conducted. In this second set of experiments, barrier-CMP processes were performed using a barrier slurry having the above-described "core" composition, according to the above-described example of Table 1, supplemented by different substances constituting the above-described first additive. Specifically, the second set of experiments were conducted for the known slurry CuS1351 (as a comparative example), for the core composition according to Table 1 (referred to below simply as "core", for conciseness), as well as for three compositions according to the second embodiment of the invention, notably:

| | |
|---|---|
| Composition A: | core with 0.01 weight percent of AOT added thereto (equivalent to 0.225-millimolar), |
| Composition B: | core + 0.225 mM sodium diisobutylsulfosuccinate (SDIBS), and |
| Composition C: | core + 0.225 mM sodium dihexylsulfosuccinate (SDHS). |

The results of these experiments are illustrated in Fg.2. (It is to be understood that the negative removal rates appearing in Fig.2 appear for the same reason as explained above with reference to Fig.1).

Fig.2 shows that the barrier slurry compositions according to the second embodiment of the invention still produce a reasonably-high removal rate of copper (about 40 nm/minute - 400 Å/minute when the first additive is AOT or SDIBS, with a slightly lower removal rate of copper when the first additive is SDHS). Furthermore, for the compositions according to the second embodiment of the invention the removal rate of Black Diamond IIX ULK dielectric material is reduced compared to the first embodiment. Moreover, once again, the water used in the second set of experiments was not ultrapure - it has been found that, when ultrapure water and the above-mentioned F-REX300S polishing tool are used, the removal rate of Black Diamond IIX is substantially equal to zero for Composition A according to the second embodiment of the invention. When the experiments were repeated using ultrapure water it was also found that the removal rate of SiO₂ was substantially the same for the compositions according to the second embodiment as for the core composition. The other results illustrated in Fig.2 are not affected to any significant extent by the water purity.

The results in Fig.2 indicate that the barrier slurry compositions according to the second embodiment of the present invention have even greater selectivity with regard to the removal of SiO₂ cap layer material preferentially relative to the underlying dielectric (or, in the case where there is no cap layer, an improved selectivity in the removal of barrier layer material preferentially relative to the underlying dielectric).

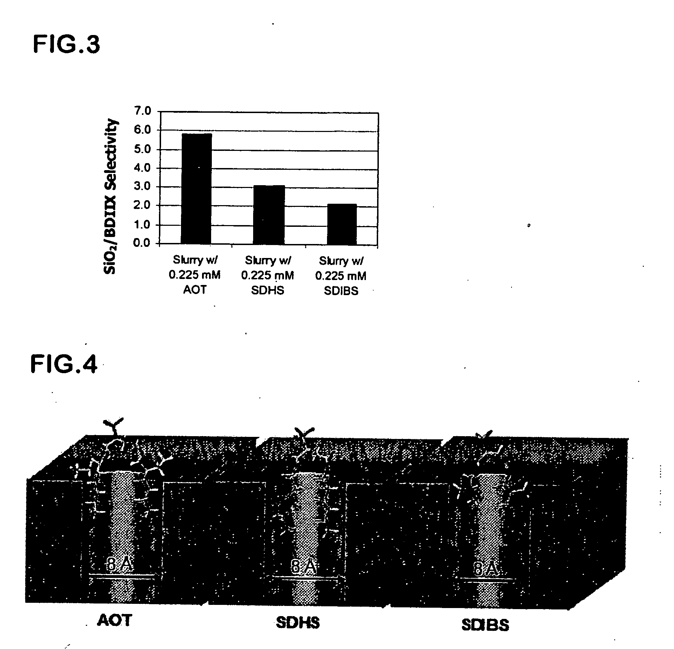

It is interesting to consider the different polish-rate selectivities that can be obtained using different barrier slurry compositions according to the second embodiment. Fig.3 illustrates the selectivity (preferential removal of SiO₂ relative to Black Diamond IIX) of the above-mentioned compositions A, B and C.

Fig.3 shows that the barrier slurry composition A, which includes AOT as the first additive, gives a higher selectivity than the compositions B and C which contain SDI BS and SDHS as the first additive. The following hypothesis can be advanced to explain the reason for the better performance obtainable using AOT.

The dimensions and configuration of AOT are such that the non-polar chains attached to the polar head may fit into the pores at the surface of a layer of Slack Diamond IIX in such a way that the non-polar branches rest against the surface of the dielectric material around the periphery of the pore. This arrangement is illustrated in Fig.4, where it is contrasted with the comparable arrangements that could be produced if SDIBS or SHDS molecules had their non-polar chains introduced into surface pores of this ULK dielectric material.

As can be seen from Fig.4, the dimensions and configuration of the AOT molecule are such that the arrangement illustrated in Fig.4 would be stable and would seal the pores at the surface of the Black Diamond IIX dielectric material. By way of contrast, although the SDIBS and SDHS molecules could adopt the arrangements illustrated in Fig.4, it is thought that these arrangements would not be so stable and probably would not seal the pores quite so effectively. (It is to be noted that, in Fig.4, the molecules have been scaled relative to the size of the pores in Black Diamond IIX). The diameter of the AOT molecule forced into the illustrated configuration corresponds to the mean diameter of a BDIIX pore, whereas the dimensions of SDIBS and SDHS do not fit so well with it.

It is currently considered that branching on the added surfactant enables a a favorable interaction with the outer surface surrounding the pore opening. The material to be pore-sealed, in our experiments, is Applied Materials BDIIX ™ and is hydrophobic. The alkyl chains do therefore have an affinity for this surface (this is also valid for the inner surface of the pores)

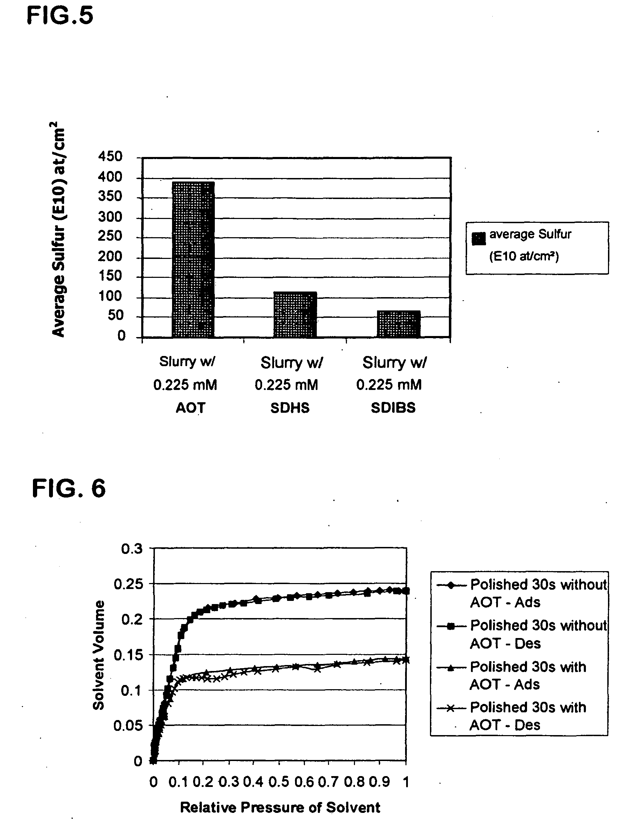

Studies have been conducted to measure the amount of sulphur remaining on the wafer surface after barrier-CMP using compositions A, B and C, followed by cleaning in a wafer scrubber (using a strong alkaline cleaning solution, notably ESC784 manufactured by ATMI). The results of these studies are illustrated in Fig.5 and show that there is a good correlation between the amounts of sulphur found on the wafer surface after cleaning and the amounts that could be expected to be found on the wafer if the above hypothesis is true (i.e. if the AOT molecules actually do seal pores in the dielectric material's surface).

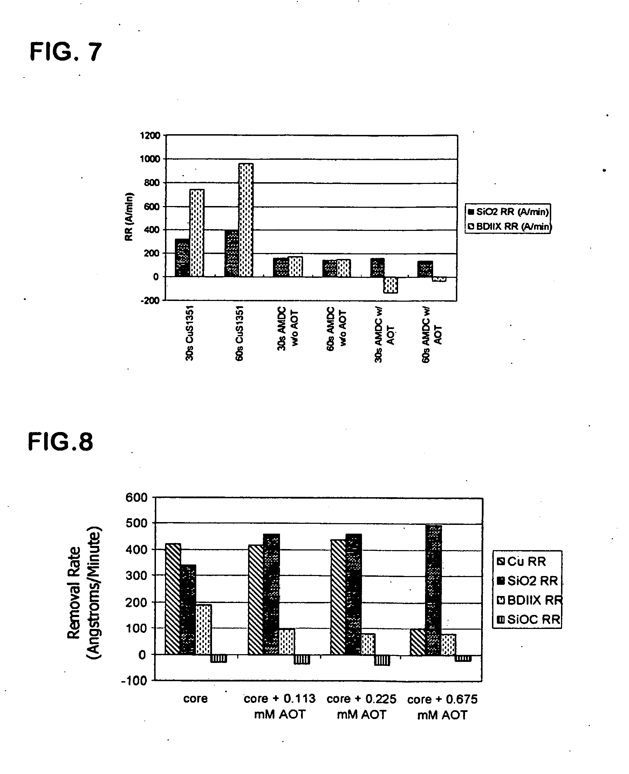

Moreover, the above hypothesis finds further support from the results of a third set of polishing tests that were carried out using the above-mentioned F-REX300S polishing tool (on full-sheet 300 mm wafers of SiO₂ and UV-cured Black Diamond IIX), in which the duration of the polishing process was varied (either 30 seconds or 60 seconds). An EP12 ellipsometer-porosimeter from SOPRA was used to compare the porosity of BDIIX wafers that had been polished for 30 seconds using the core composition with and without AOT. The plots marked "without AOT-Ads" and "without AOT-Des" in Figure 6 were obtained using the "core composition" referred to above (Table 1) without the first additive (surfactant). "Ads" and "Des" here stand respectively for the "Adsorption" and "Desorption" curves in this ellipso-porosimetry test using adsorption and desorption of toluene solvent. The wafers polished using the composition including AOT show a dramatic porosimetry decrease, from 24% to 14%. This indicates the pore sealing effect of the AOT molecules. This pore sealing is believed to stop or lower the polish rate on BDIIX. The porosimetry data are illustrated in Fig.6. This third set of polishing tests produced the removal rate data shown in Rg.7. This data confirms that the core compositions according to the first embodiment of the invention have improved selectivity of removal of SiO₂ relative to Black Diamond IIX. With regard to the compositions according to the second embodiment of the invention, the data confirms the influence of AOT on the SiO₂ vs BDIIX selectivity. As illustrated in Fig.7, the barrier slurry compositions including AOT (marked "AMDC w/ AOT') produce negligible polishing of BDIIX (negative removal rates in Fig.7 arise because of the ellipsometer artefact described above). The SiO₂ removal rates obtained with the core composition of the slurry (no additives; marked "AMDC w/o AOT') are somewhat lower than those obtained on the Mirra tool (200 mm wafers, in Figures 1 to 3). This can be explained by the tool differences and by the two different BDIIX wafer sources, used on the Mirra and F-REX300S tools. Indeed, as mentioned above, the wafers polished on the Mirra tool were e-beam cured and those polished on the F-REX300S tool were UV-cured. Incidentally, the removal rates have been measured with various polish times, 30 and 60 seconds, so as to ensure that the tool starts polishing at a normal rate without too significant a delay due to initial warm-up of the apparatus.

Further experiments have been performed with regard to the second embodiment of the invention in order to determine the effect of including different amounts of AOT in the core composition. In particular, Fig.8 illustrates the removal rates of copper, SiO₂ cap layer material, SiOC and Black Diamond IIX dielectric materials for barrier slurry compositions corresponding to core+ 0.113mM AOT, core + 0.225 mM AOT and core + 0.675 mM AOT, using the core barrier slurry composition according to the Table 1 example of the first embodiment as a comparative example. These experiments were performed on full-sheet wafers of SiO₂ and Black Diamond IIX; in the case of Black Diamond- IIX the sheet was cured using an electron beam and did not have a plasma finish. A polishing pressure of 13 789.514 Pascals (2 psi) was applied during these experiments, in the above-mentioned Mirra polishing tool.

It is observed in such experiments that an increase of AOT concentration from 0.225 mM to 0.675 mM does not improve selectivity on BDIIX, and since use of extra reagent increases cost and may increase potential contamination problems, an advantageous concentration of AOT or analogous surfactants is around 0.225 mM (equivalent 0.01 wt. %, an appropriate range being from 0.005 to 0.02 wt. %).

As discussed above, at the same molar concentration of 0.225 mM, cousin molecules of AOT have been tested, namely sodium diisobutyl sulfosuccinate where both the branching and the alkyl chain length are different, and sodium dihexyl sulfosuccinate, which is equivalent to AOT but without the branching.

The beneficial effect of the branching is clear, since it allows a gain in selectivity from 3 to 6 (see Fig. 2). The short alkyl chains of the sodium diisobutyl sulfosuccinate, although branched, do not bring very much more selectivity as compared with the case where no surfactant was added.

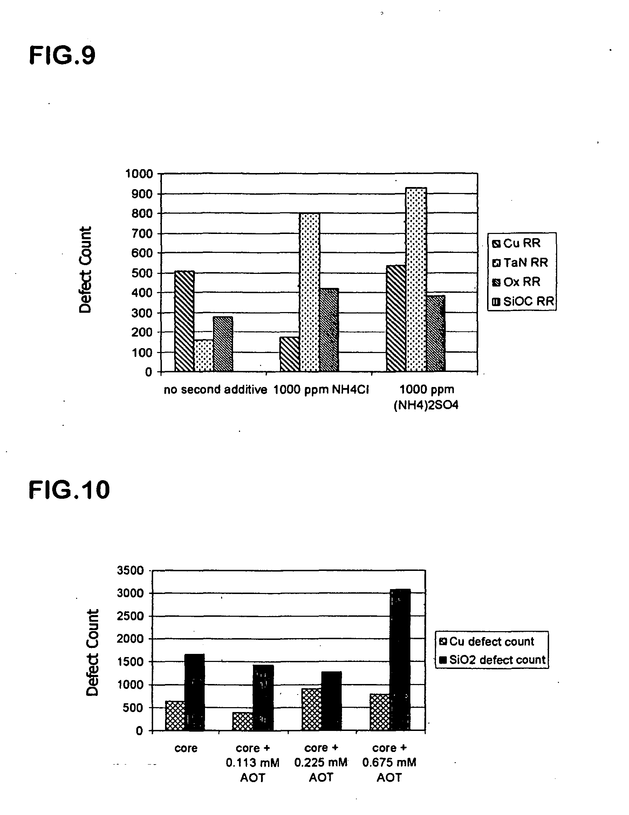

Fig.9 illustrates observed defectivity data measured after performing barrier-CMP using the compositions of Fig.B.

It can be seen from Figures 8 and 9 that the optimum compromise between obtaining acceptable defectivity and still having a good selectivity of removal of SiO₂ preferentially relative to Black Diamond IIX or SiOC (Black Diamond I) is obtained when AOT is added to the core composition so as to be present in an amount of 0.01 weight percent (corresponding to 0.225 mM) in the final composition. The barrier slurry composition A including this amount of AOT yields the following set of removal rates:

| | |
|---|---|
| Removal Rate of Copper : | 50.6 nm/min (506 Almin) |
| Removal Rate of TaN : | 15.7 nm/min (157Å/min) |
| Removal Rate of SiO₂ : | 27.5 nm/min (275 Å/min) |
| Removal Rate of SiOC : | 0 nm/min (0 Å/min) |
| Removal Rate of BDIIX : and | 7.9 nm/min (79 Å/min) |
| Selectivity of SiO₂/BDI: | total |
| Selectivity of SiO₂/BDI X: | 3.5. |

Moreover, after CMP using this barrier slurry composition there is no observable pitting on the copper, the total copper defectivity count per wafer without a chemical rinse is 902 and for SiO₂ (still without a chemical rinse) it is 1260. This compares very favourably with the total copper defectivity count per wafer observed when using a conventional barrier slurry (which, for the above-mentioned barrier slurry CuS1351 is 2105 (without a chemical rinse)), and compares satisfactorily with the total defectivity count per wafer for SiO₂ (again without a chemical rinse) observed when using CuS1351 (which is 805).

The above-described experimental results were produced using a Mirra polishing tool to polish Black Diamond IIX layers cured by the old technique of electron-beam curing. When the BDI IX wafers are UV cured, as is usual nowadays, the removal rates on BDIIX are negligible and the SiO₂ vs BDIIX selectivity becomes total, as shown in Fig.7.

### Third Embodiment

The third embodiment of the present invention will now be described:

It has now been found that it can be advantageous to introduce a second additive into the core composition described above, either on its own or in association with the above-mentioned first additive. In particular, it has now been found to be advantageous to make use of a second additive which is selected from the family consisting of the salts of ammonia, sodium or potassium, advantageously the nitrates, sulphates or chlorides.

By adding the second additive to the core composition according to the first embodiment, so that the second additive is present at an amount of 0.1 weight percent in the final composition, it has now been found that it is possible to increase the removal rate of the barrier material (here TaN) obtained during barrier-CMP using the resultant composition, without significantly affecting the removal rates of SiO₂ or copper. Advantageously, the salt added as a (second) additive is present in the composition in an amount ranging from 0.02 to 0.5 wt. % with respect to the total weight of the composition.

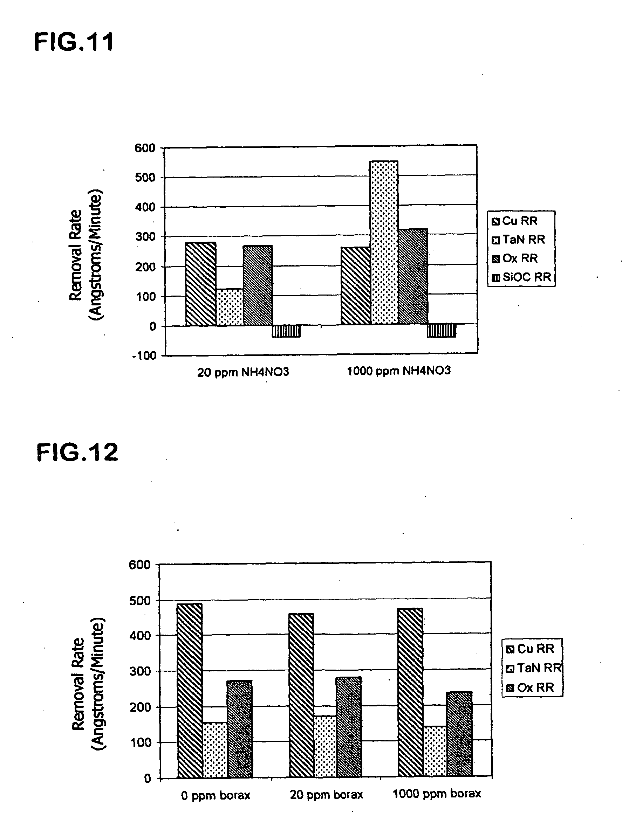

Figure 9 shows the impact of these salts on the various removal rates. In particular, it shows the effect of using NH₄Cl and (NH₄)₂SO₄ as the second additive. Figure 11 shows that a similar salt (here NH₄NO₃) added at various concentrations allows to tune the barrier material (here TaN) removal rate. Finally Figure 12 illustrates that some salts, such as borax, do not have any impact on the barrier removal rate. Also, it can be seen that the removal rates of the copper and SiO₂ are not too affected by the added salts, meaning that their removal rates remain fully compatible with the expected performances of a barrier slurry.

In a barrier CMP process using a slurry according to the third embodiment, and consisting of the core composition plus the first additive as well as the second additive, the selectivity of the process with regard to the preferential removal of barrier layer material relative to the underlying low-k or ULK dielectric is substantially total (in a case where there is no cap layer).

### Barrier-CMP Methods

Various different barrier-CMP methods can be implemented using the barrier slurry compositions according to the invention.

I n a first barrier-CMP method according to the present invention the same barrier slurry composition is used substantially throughout the whole of the barrier-CMP process. This composition can be the composition according to the first, second or third embodiments of the present invention, in other words the barrier slurry used throughout the barrier-CMP process can be any of:
the core composition alone,
the core composition supplemented by the first additive,
the core composition supplemented by the second additive, or
the core composition supplemented by the first and second additives.

In a second barrier-CMP method according to the present invention the barrier slurry composition is changed part way through the barrier-CMP process, notably when the outer region of the barrier layer (and, possibly, part of the cap layer) has been polished and the polishing interface is getting close to the underlying low-k or ULK dielectric layer.

The reasoning behind this approach is the realization that, during the initial stage of the barrier-CMP process, the polishing process is relatively far from the underlying low-k or ULK dielectric and so it is not so critical to consider the effect of the polishing conditions on the removal rate of the low-k or ULK dielectric: However, when the polishing approaches the boundary between the cap layer and the underlying low-k or ULK dielectric (or, if there is no cap layer, the boundary between the barrier layer and the low-k or ULK dielectric), then the selectivity of the barrier-CMP process relative to the dielectric material becomes more important.

In the second barrier-CMP method according to the invention, it is advantageous if, at the start of barrier-CMP, the barrier slurry composition corresponds to the core composition according to the first embodiment of the invention, or with the second additive, in order too increase the removal rate on the barrier material. Later on, when the polishing interface is approaching the boundary of the low-k or ULK dielectric material, it is advantageous to add the first additive in order to produce a slurry composition according to the second embodiment of the invention, and possibly at the same time decrease the first additive concentration to lower the barrier removal rate. Alternatively, just the second additive, or both the first and second additives, can be introduced at this stage, so as to produce a barrier slurry composition according to the third embodiment of the invention.

In a case where there is a cap layer, it can be advantageous if the first additive is introduced when polishing of the cap layer material has already begun (using either the core composition alone or the core composition supplemented with the second additive), but relatively early into polishing of the cap layer. In this way, the change in selectivity will take effect before the underlying low-k dielectric material has been exposed. The first additive (surfactant) increases selectivity vis-a-vis the ULK material (such as BDIIX), whereas the second additive increases the speed at which the barrier is removed. As a practical matter the change will generally be implemented after the "endpoint", i.e. after the majority of the barrier material has cleared. Typically, cap layers are around 50-100 nm (500-1000 Angstroms) thick and so it would be preferable to implement the change in polishing conditions wen the remaining thickness of cap layer material over the dielectric layer is greater than about 20-30 nm.

If there is no cap layer, the first additive can be added to the core composition or, more probably to the core composition plus the second additive, at a time when the barrier polish is approaching the interface with the underlying low-k or ULK dielectric.

A number of different techniques may be chosen for controlling the introduction of the first and/or second additives. More particularly, the additive(s) may be introduced at a fixed time after the start of barrier-CMP. Another alternative is to determine the appropriate time point for introduction of additive(s) by using a measurement system to dynamically set the timing depending upon that measurement system's evaluation of how polishing is progressing. The measurement system may choose an instant that is related to the endpoint of barrier CMP (as determined by in-situ measurements of properties, such as layer thickness, during the barrier polish of the current wafer), or it may be an automatic process control (APC) system that takes measurements on a succession of wafers and varies the time point for introduction of additive(s) on a run-to-run (or wafer-to-wafer or lot-to-lot) basis, dependent on measurements made for one or more preceding wafers.

Still further, the unit controlling the introduction of additive(s) may be arranged to modify the timing of introduction dependent on historical data relating to repeatable factors, such as a drift in the removal rate as a polishing pad or the like wears. For example, if the removal rate of material by a polishing pad drops by x% per wafer polished, the control unit could delay the time of introduction of additive(s) by an extra kx seconds per wafer until the polishing pad is replaced.

If desired, the operating conditions may be modified at the same time as a change is made in the barrier slurry composition by introduction of the first and/or second additives. Changes in operating conditions may include changes in wafer rotational velocity, wafer speed across the platen, down force, platen rotational velocity, temperature at the wafer surface, and/or slurry flow rate.

If a decrease in the second additive concentration is requested to decrease the barrier removal rate at the end of the barrier polish step, at the endpoint described above for example, a slurry with a another composition can substitute the first one, with the corresponding lower second additive concentration. It is also possible to add the first additive only in that second slurry composition, to increase the selectivity towards BDIIX at that moment.

### Apparatus

Barrier-CMP method using barrier slurry compositions according to the present invention can be implemented using a wide range of CMP tools such as a Reflexion or Mirra CMP tool manufactured by Applied Materials Inc., the above-mentioned F-REX300S CMP tool manufactured by Ebara, etc. Typically, the barrier CMP process can produce good results with a polishing pressure of around (1-2 psi). However, the present invention is not particularly limited with reference to the tool used for implementing the barrier polish or with regard to the polishing pressure.

### Variations

Although the present invention has been described with reference to particular embodiments thereof, it is to be understood that the present invention is not limited by reference to the particularities of the above-described embodiments. More particularly, the skilled person will readily appreciate that modifications and developments can be made in the-above-described embodiments without departing from the scope of the invention as defined in the accompanying claims.

For example, although the various embodiments have been described in a context in which the barrier CMP is being performed on a TaN barrier layer material, it is to be understood that the present invention is also applicable to barrier CMP of other conventional barrier layer materials (for example, Ta, TiN, etc.).

Slmilarly, although the various embodiments have been described in a context in which the cap barrier material is SiO₂, it is to be understood that the present invention is also applicable when other cap layer materials are used, such as BDI or a modified BDIIX.

Moreover, although the various embodiments have been described in a context in which the barrier layer underlies Cu metallization, it is to be understood that the present invention is also applicable when other metallic materials are used instead of Cu (for example, Al, Ag, W, etc.).

## Claims

1. An aqueous barrier slurry composition having a pH of 7.0 or below, the said composition comprising:
a) 0.001 % to 0.05 % by weight of oxidizing agent;
b) 1 to 10 % by weight of abrasive;
c) 0.01 to 3 % by weight of complexing agent;
d) 0 to 2 % by weight of corrosion inhibitor;
each amount of components (a) to (d) being expressed with respect to the total weight of the aqueous composition.

2. The aqueous barrier slurry composition according to claim 1, wherein the oxidizing agent is hydrogen peroxide.

3. The aqueous barrier slurry composition according to claim 1 or claim 2, wherein the abrasive is an inorganic oxide, preferably containing silica particles.

4. The aqueous barrier slurry composition according to any of claims 1 to 3, wherein the complexing agent comprises one or more of the group consisting of: a molecule containing hydroxyl- and/or carboxylate functional groups.

5. The aqueous barrier slurry composition according to any of claims 1 to 4 , wherein the composition further comprises a compound (1) having the following structure: 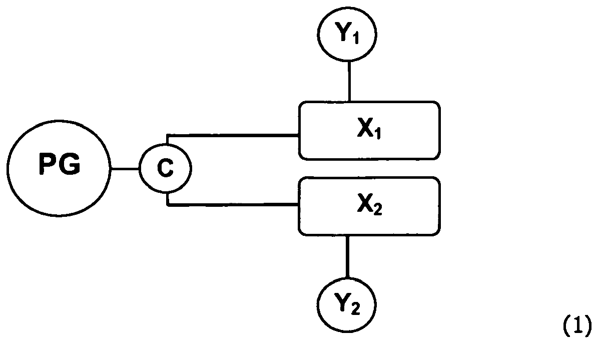 where:
PG is a polar group or charged group,
C is a dicarboxylate unit of formula -O-C(O)-R-C(O)-, where the carboxylate groups form ester linkages with X₁ and X₂, and the R group is covalently bound to polar or charged group PG;
X₁ and X₂ are each non-polar chains or a chain at least a portion of which is non-polar;
Y₁ and Y₂ are each a non-polar chain branching off from X₁ and X₂;
wherein X₁ may have one or more branches additional to Y₁ and X₂ may have one or more branches additional to Y_{2.}

6. The aqueous barrier slurry composition according to claim 5, wherein the polar group PG is a sulfate, a phosphate, an alkyl ammonium, a carboxylate, a sulfonate, a thiol, an alcohol, an ether, a thioether, an ethylene oxide, a propylene oxide, or an amine.

7. The aqueous barrier slurry composition according to either of claims 5 or 6, wherein X₁ and X₂ may be unsubstituted or substituted alkyl or alkenyl chains, or chains that consist of or comprise polysilane or polysiloxane or fluorocarbon (fluoroalkyl) chains.

8. The aqueous barrier slurry composition according to any of claims 5 to 7, wherein branches Y₁ and Y₂ are alkyl or alkenyl chains containing 1 to 20 carbon atoms.

9. The aqueous barrier slurry composition according to any of claims 5 to 8, wherein the added compound (1) is a branched dialkyl sulfosuccinate.

10. The aqueous barrier slurry composition according to any of claims 5 to 9, wherein the polar group is an anionic group having a counter-ion selected from the group consisting of sodium, potassium, ammonium or alkylammonium.

11. The aqueous barrier slurry composition according to claim 9 or claim 10, wherein the added compound (1) is sodium bis(2-ethylhexyl) sulfosuccinate (AOT).

12. The aqueous barrier slurry composition according to any of claims 5 to 11, wherein the compound (1) is added in an amount of 0.005 to 0.02 wt. % with respect to the total weight of the composition.

13. The aqueous barrier slurry composition according to any of claims 1 to 12, the composition further comprising a salt selected from the family consisting of: nitrates, chlorides and sulphates of ammonium, potassium and sodium.

14. The aqueous barrier slurry composition according to claim 13, wherein the salt is present in the composition in an amount ranging from 0.02 to 0.5 wt. % with respect to the total weight of the composition.

15. A barrier chemical mechanical polishing method (CMP) for polishing a metal-diffusion barrier material in a structure provided on a semiconductor wafer, the structure having a low-k dielectric layer, comprising the addition of an aqueous barrier slurry composition according to any of claims 1 to 14.

## Patentansprüche

1. Wässrige Barriereschlammzusammensetzung mit einem pH-Wert von 7,0 oder weniger, wobei die Zusammensetzung umfasst:
a) 0,001 % bis 0,05 % Massenanteil Oxidationsmittel;
b) 1 bis 10 % Massenanteil Schleifmittel;
c) 0,01 bis 3 % Massenanteil Komplexbildner;
d) 0 bis 2 % Massenanteil Korrosionsschutzmittel;
wobei jede Menge der Komponenten (a) bis (d) in Bezug auf das Gesamtgewicht der wässrigen Zusammensetzung ausgedrückt ist.

2. Wässrige Barriereschlammzusammensetzung gemäß Anspruch 1, wobei das Oxidationsmittel Wasserstoffperoxid ist.

3. Wässrige Barriereschlammzusammensetzung gemäß Anspruch 1 oder Anspruch 2, wobei das Schleifmittel ein anorganisches Oxid ist, vorzugsweise Siliciumdioxid-Partikel enthaltend.

4. Wässrige Barriereschlammzusammensetzung gemäß einem der Ansprüche 1 bis 3, wobei der Komplexbildner eines oder mehrere aus der Gruppe umfasst, die besteht aus: einem Molekül beinhaltend Hydroxyl- und/oder Carboxylat-Funktionsgruppen.

5. Wässrige Barriereschlammzusammensetzung gemäß einem der Ansprüche 1 bis 4, wobei die Zusammensetzung ferner eine Verbindung (1) mit der folgenden Struktur umfasst: 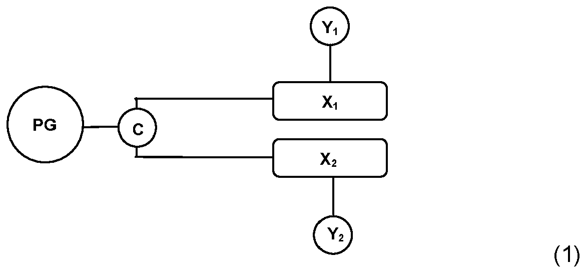 wobei:
PG eine polare Gruppe oder geladene Gruppe ist,
C eine Dicarboxylat-Einheit der Formel -O-C(O)-R-C(O)- ist, wobei die CarboxylatGruppen Ester-Bindungen mit X₁ und X₂ bilden und die R-Gruppe kovalent an die polare oder geladene Gruppe PG gebunden ist;
X₁ und X₂ jeweils nicht-polare Ketten oder eine Kette, bei der zumindest ein Teil nichtpolar ist, sind;
Y₁ und Y₂ jeweils eine nicht-polare Kette sind, die von X₁ und X₂ abzweigen;
wobei X₁ eine oder mehrere Abzweigungen zusätzlich zu Y₁ haben kann und X₂ eine oder mehrere Abzweigungen zusätzlich zu Y₂ haben kann.

6. Wässrige Barriereschlammzusammensetzung gemäß Anspruch 5, wobei die polare Gruppe PG ein Sulfat, ein Phosphat, ein Alkylammonium, ein Carboxylat, ein Sulfonat, ein Thiol, ein Alkohol, ein Ether, ein Thioether, ein Ethylenoxid, ein Propylenoxid oder ein Amin ist.

7. Wässrige Barriereschlammzusammensetzung gemäß Anspruch 5 oder 6, wobei X₁ und X₂ unsubstituierte oder substituierte Alkyl- oder Alkenylketten oder Ketten sein können, die aus Polysilan- oder Polysiloxan- oder Fluorkohlenstoff(Fluoralkyl)-Ketten bestehen oder diese umfassen.

8. Wässrige Barriereschlammzusammensetzung gemäß einem der Ansprüche 5 bis 7, wobei die Abzweigungen Y₁ und Y₂ Alykl- oder Alkenylketten sind, die 1 bis 20 Kohlenstoffatome umfassen.

9. Wässrige Barriereschlammzusammensetzung gemäß einem der Ansprüche 5 bis 8, wobei die hinzugefügte Verbindung (1) ein verzweigtes Dialkyl-Sulfosuccinat ist.

10. Wässrige Barriereschlammzusammensetzung gemäß einem der Ansprüche 5 bis 9, wobei die polare Gruppe eine anionische Gruppe mit einem Gegenion ist, ausgewählt aus der Gruppe, die aus Natrium, Kalium, Ammonium oder Alkylammonium besteht.

11. Wässrige Barriereschlammzusammensetzung gemäß Anspruch 9 oder Anspruch 10, wobei die hinzugefügte Verbindung (1) Natrium-Bis(2-Ethylhexyl)-Sulfosuccinat (AOT) ist.

12. Wässrige Barriereschlammzusammensetzung gemäß einem der Ansprüche 5 bis 11, wobei die Verbindung (1) hinzugefügt ist in einer Menge von 0,005 bis 0,02 % Massenanteil in Bezug auf das Gesamtgewicht der Zusammensetzung.

13. Wässrige Barriereschlammzusammensetzung gemäß einem der Ansprüche 1 bis 12, wobei die Zusammensetzung ferner ein Salz umfasst, das aus der Familie ausgewählt ist, die besteht aus: Nitraten, Chloriden und Sulfaten von Ammonium, Kalium und Natrium.

14. Wässrige Barriereschlammzusammensetzung gemäß Anspruch 13, wobei das Salz in der Zusammensetzung in einer Menge vorhanden ist, die im Bereich von 0,02 bis 0,5 % Massenanteil im Bezug auf das Gesamtgewicht der Zusammensetzung liegt.

15. Chemisch-mechanisches Barriere-Polier-Verfahren (CMP) zum Polieren eines Metall-Diffusionsbarriere-Materials in einer auf einem Halbleiter-Wafer bereitgestellten Struktur, wobei die Struktur eine low-k-dielektrische Schicht hat, umfassend das Hinzufügen einer wässrigen Barriereschlammzusammensetzung gemäß einem der Ansprüche 1 bis 14.

## Revendications

1. Composition aqueuse de coulis pour barrière ayant un pH de 7,0 ou inférieur, ladite composition comprenant :
a) 0,001 % à 0,05 % en poids d'agent oxydant;
b) 1 à 10 % en poids d' abrasif ;
c) 0,01 à 3 % en poids d'agent complexant ;
d) 0 à 2 % en poids d'inhibiteur de corrosion ;
chaque quantité des composants (a) à (d) étant exprimée par rapport au poids total de la composition aqueuse.

2. Composition aqueuse de coulis pour barrière selon la revendication 1, dans laquelle l'agent oxydant est du peroxyde d'hydrogène.

3. Composition aqueuse de coulis pour barrière selon la revendication 1 ou la revendication 2, dans laquelle l'abrasif est un oxyde inorganique, de préférence contenant des particules de silice.

4. Composition aqueuse de coulis pour barrière selon l'une quelconque des revendications 1 à 3, dans laquelle l'agent complexant comprend un ou plusieurs des groupes constitués par : une molécule contenant des groupes fonctionnels hydroxyle et/ou carboxylate.

5. Composition aqueuse de coulis pour barrière selon l'une quelconque des revendications 1 à 4, dans laquelle la composition comprend en outre un composé (1) ayant la structure suivante : 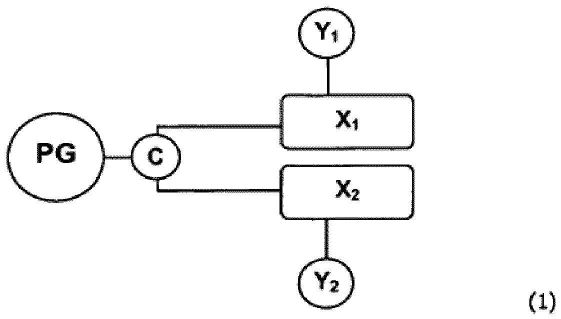 dans laquelle :
PG représente un groupe polaire ou un groupe chargé,
C représente un motif dicarboxylate de formule -O-C(O)-R-C(O)-, dans lequel les groupes carboxylate forment des liaisons ester avec X₁ et X₂, et le groupe R est lié de manière covalente au groupe PG polaire ou chargé ;
X₁ et X₂ représentent chacun des chaînes non polaires ou une chaîne dont une portion au moins est non polaire ;
Y₁ et Y₂ représentent chacun une ramification de chaîne non polaire issue de X₁ et X₂,
structure dans laquelle X₁ peut avoir une ou plusieurs ramifications en supplément de Y₁ et X₂ peut avoir une ou plusieurs ramifications en supplément de Y_{2.}

6. Composition aqueuse de coulis pour barrière selon la revendication 5, dans laquelle le groupe PG polaire est un sulfate, un phosphate, un alkylammonium, un carboxylate, un sulfonate, un thiol, un alcool, un éther, un thioéther, un oxyde d'éthylène, un oxyde de propylène, ou une amine.

7. Composition aqueuse de coulis pour barrière selon l'une des revendications 5 ou 6, dans laquelle X₁ et X₂ peuvent être des chaînes de type alkyle ou alcényle non substituées ou substituées, ou bien des chaînes qui sont constituées de ou comprennent des chaînes de type polysilane ou polysiloxane ou de type fluorocarbone (fluoroalkyle).

8. Composition aqueuse de coulis pour barrière selon l'une quelconque des revendications 5 à 7, dans laquelle les ramifications Y₁ et Y₂ sont des chaînes de type alkyle ou alcényle contenant 1 à 20 atomes de carbone.

9. Composition aqueuse de coulis pour barrière selon l'une quelconque des revendications 5 à 8, dans laquelle le composé (1) ajouté est un dialkylsulfosuccinate ramifié.

10. Composition aqueuse de coulis pour barrière selon l'une quelconque des revendications 5 à 9, dans laquelle le groupe polaire est un groupe anionique ayant un ion complémentaire choisi dans le groupe constitué par le sodium, le potassium, l'ammonium ou l'alkylammonium.

11. Composition aqueuse de coulis pour barrière selon la revendication 9 ou la revendication 10, dans laquelle le composé (1) ajouté est du bis(2-éthylhexyl) sulfosuccinate de sodium (AOT).

12. Composition aqueuse de coulis pour barrière selon l'une quelconque des revendications 5 à 11, dans laquelle le composé (1) est ajouté en une quantité de 0,005 à 0,02 % en poids par rapport au poids total de la composition.

13. Composition aqueuse de coulis pour barrière selon l'une quelconque des revendications 1 à 12, la composition comprenant en outre un sel choisi dans la famille constituée par : les nitrates, les chlorures et les sulfates d'ammonium, de potassium et de sodium.

14. Composition aqueuse de coulis pour barrière selon la revendication 13, dans laquelle le sel est présent dans la composition en une quantité se situant entre 0,02 et 0,5 % en poids par rapport au poids total de la composition.

15. Procédé de polissage mécano-chimique de barrière (CMP) pour le polissage d'une matière de barrière à diffusion de métal dans une structure prévue sur une tranche de semi-conducteur, la structure ayant une couche diélectrique à faible k, comprenant l'addition d'une composition aqueuse de coulis pour barrière selon l'une quelconque des revendications 1 à 14.
